# EUROPEAN PATENT APPLICATION

(11) **EP 3 131 130 A1**
(43) Date of publication of application: **15.02.2017**
(21) Application number: 16183494.0
(22) Date of filing: 10.08.2016
(51) Int. Cl.: H01L 33/42, H01L 33/46, H01L 33/32, H01L 33/38, H01L 33/40, H01L 33/62

(54) **SEMICONDUCTOR LIGHT EMITTING STRUCTURE**

(30) Priority: 13.08.2015 TW 104126374
(71) Applicant: Lextar Electronics Corp., 30075 Hsinchu (TW)
(72) Inventor: Kuo, Shiou-Yi, 806 Kaohsiung City (TW); Wang, Te-Chung, 411 Taichung City (TW); Lai, Shih-Huan, 515 Changhua County (TW)
(74) Representative: dompatent von Kreisler Selting Werner - Partnerschaft von Patent- und Rechtsanwälten mbB

(57) **Abstract**

A semiconductor light emitting structure (100A;100B;100C;100D) includes a first type semiconductor layer (104), an active layer (105), a second type semiconductor layer (106), an electrode, a transparent conductive layer (107), a Bragg reflective layer (108) and a metal layer (109). The second type semiconductor layer (106), the active layer (105) and the first type semiconductor layer (104) are stacked sequentially to form an epitaxial layer (103). The electrode is formed on the first type semiconductor layer (104). The transparent conductive layer (107) is formed on the second type semiconductor layer (106). The Bragg reflective layer (108) is formed on the transparent conductive layer (107). The Bragg reflective layer (108) and electrode are disposed on opposite sides of the epitaxial layer (103). The metal layer (109) is formed on the Bragg reflective layer (108). The Bragg reflective layer (108) has a concave portion into which the metal layer (109) is put. The metal layer (109) has a current conducting portion embedded into the concave portion and electrically connected to the transparent conductive layer (107).

## Description

### BACKGROUND OF THE INVENTION

### Field of the Invention

The invention relates in general to a semiconductor light emitting structure, and more particularly to a semiconductor light emitting structure including a transparent conductive layer and a Bragg reflective layer.

### Description of the Related Art

Light emitting diode (LED) emits a light by way of converting an electric energy into an optical energy. After a current is applied to an LED, the current is diffused and injected to the epitaxy layer of the LED, such that electrons and holes are combined and energy is released and emitted in the form of a light. LED has the advantages of long life-span, low power consumption and small volume. In recent years, along with the development in the technology of wide color gamut and high brightness, LED has been used in the field of white light emitting to replace the conventional fluorescent tube.

During the manufacturing process of the vertical LED or the flip-chip LED, a metal, such as aluminum or silver, is normally adopted to be a reflector of LED to increase the luminous efficiency of LED. However, silver is susceptible to acid and moisture, and erodes easily. Besides, when an Ohmic contact layer formed of silver is disposed between a metal layer and the semiconductor layer, the electro-migration phenomenon might easily occur to the silver layer. Since the material of the barrier layer and the protection layer for covering the silver layer completely must be specifically selected to avoid silver layer failure, the manufacturing cost will increase accordingly.

### SUMMARY OF THE INVENTION

The invention is directed to a semiconductor light emitting structure using a laminated structure of a transparent conductive layer and a Bragg reflective layer to increase the overall luminous efficiency.

The invention is directed to a semiconductor light emitting structure using a laminated structure of a transparent conductive layer and double Bragg reflective layers to increase the overall luminous efficiency.

According to one embodiment of the present invention, a semiconductor light emitting structure including a first type semiconductor layer, an active layer, a second type semiconductor layer, an electrode, a transparent conductive layer, a Bragg reflective layer and a metal layer is provided. The second type semiconductor layer, the active layer and the first type semiconductor layer are stacked sequentially to form an epitaxy layer. The electrode is formed on the first type semiconductor layer. The transparent conductive layer is formed on the second type semiconductor layer. The Bragg reflective layer is formed on the transparent conductive layer. The Bragg reflective layer and the electrode are disposed on opposite sides of the epitaxy layer. The metal layer is formed on the Bragg reflective layer. The Bragg reflective layer has a first concave portion into which the metal layer is put, such that the metal layer has a current conducting portion embedded into the first concave portion and electrically connected to the transparent conductive layer.

According to another embodiment of the present invention, a semiconductor light emitting structure including a first type semiconductor layer, an active layer, a second type semiconductor layer, a first Bragg reflective layer, a transparent conductive layer, a second Bragg reflective layer and a metal layer is provided. The second type semiconductor layer, the active layer and the first type semiconductor layer are stacked sequentially to form an epitaxy layer. The first Bragg reflective layer is formed on the second type semiconductor layer. The transparent conductive layer is formed on the first Bragg reflective layer. The second Bragg reflective layer is formed on the transparent conductive layer. The first Bragg reflective layer has a first recess into which the transparent conductive layer and the second Bragg reflective layer are put, such that the transparent conductive layer has a current diffusion portion embedded into the first recess. The metal layer is formed on the second Bragg reflective layer. The second Bragg reflective layer has a second recess into which the metal layer is put, such that the metal layer has a current conducting portion embedded into the second recess and electrically connected to the transparent conductive layer.

The above and other aspects of the invention will become better understood with regard to the following detailed description of the preferred but non-limiting embodiment(s). The following description is made with reference to the accompanying drawings.

### BRIEF DESCRIPTION OF THE DRAWINGS

FIG. 1 is a cross-sectional view of a semiconductor light emitting structure according to an embodiment of the invention.
FIG. 2 is a cross-sectional view of a semiconductor light emitting structure according to an embodiment of the invention.
FIG. 3 is a cross-sectional view of a semiconductor light emitting structure according to an embodiment of the invention.
FIG. 4 is a cross-sectional view of a semiconductor light emitting structure according to an embodiment of the invention.
FIG. 5 is a cross-sectional view of a semiconductor light emitting structure according to an embodiment of the invention.
FIG. 6 is a cross-sectional view of a semiconductor light emitting structure used as vertical LED according to an embodiment of the invention.
FIG. 7 is a cross-sectional view of a semiconductor light emitting structure used as a flip-chip LED according to an embodiment of the invention.

### DETAILED DESCRIPTION OF THE INVENTION

A semiconductor light emitting structure, such as a vertical LED, is provided in the present invention. The semiconductor light emitting structure has a first electrode and a second electrode which are disposed on two opposite sides. The first electrode arranged in the form of meshes, strips or dots is disposed on the topmost of the epitaxy layer. A Bragg reflective layer arranged in the form of meshes, strips or dots is disposed under the part of the epitaxy layer corresponding to the first electrode. In an embodiment, the Bragg reflective layer is formed on the transparent conductive layer, and the metal layer is formed on the Bragg reflective layer. The Bragg reflective layer can be used as a reflective mirror of the vertical LED, such that the reflectivity of the light with a wavelength within the range of visible light or UV light (such as between 340nm∼420nm or between 360nm∼400nm) can reach 90% and above or even 100%. The transparent conductive layer can make the current uniformly diffused to the second type semiconductor layer and can be used as an Ohmic contact layer between the metal layer and the second type semiconductor layer to reduce the contact impedance between the metal layer and the second type semiconductor layer.

A semiconductor light emitting structure, such as a flip-chip LED, is provided in the present invention. The semiconductor light emitting structure has a first electrode and a second electrode disposed on the same side. In an embodiment, the transparent conductive layer is formed on the first Bragg reflective layer. The second Bragg reflective layer is formed on the transparent conductive layer. The first and the second Bragg reflective layers can be used as a reflective mirror of the flip-chip LED, such that the reflectivity of the light with a wavelength within the range of visible light or UV light (such as between 340nm∼420nm or between 360nm∼400nm), can reach 90% and above or even 100%. The transparent conductive layer can make the current uniformly diffused to the second type semiconductor layer and can be used as an Ohmic contact layer between the metal layer and the second type semiconductor layer to reduce the contact impedance between the metal layer and the second type semiconductor layer.

A number of embodiments are disclosed below for elaborating the invention. However, the embodiments of the invention are for detailed descriptions only, not for limiting the scope of protection of the invention.

### First Embodiment

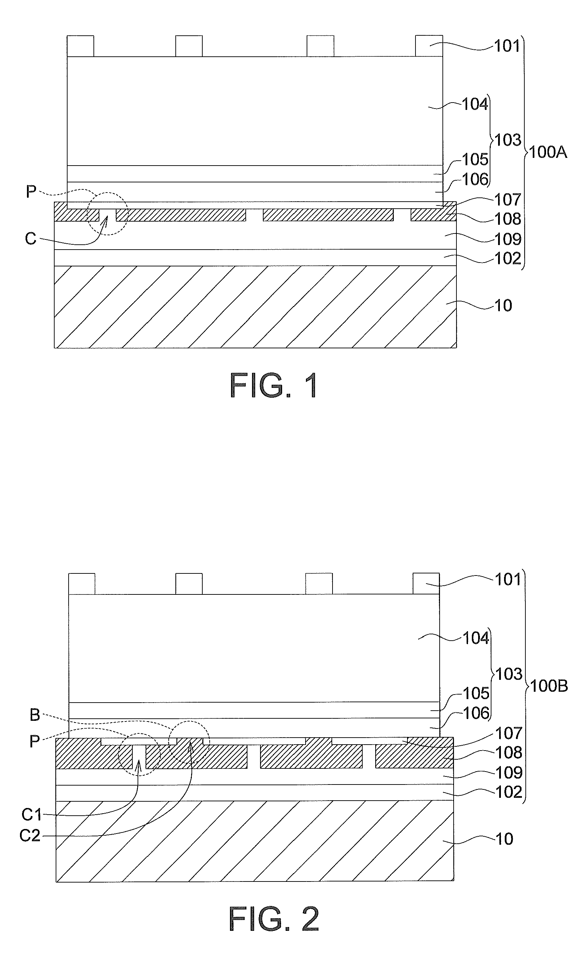

Referring to FIG. 1, a cross-sectional view of a semiconductor light emitting structure 100A according to an embodiment of the invention is shown. The semiconductor light emitting structure 100A is disposed on a carrier 10. The carrier 10 can be a silicon substrate, a silicon carbide substrate, or a ceramic substrate. The semiconductor light emitting structure 100A includes a first electrode 101 and a second electrode 102 which are disposed on two opposite sides. The first electrode 101 (such as an N-type electrode) can be electrically connected to the negative polarity of a power supply circuit board (not illustrated) through wires (not illustrated), and the second electrode 102 (such as a P-type electrode) can be electrically connected to the positive polarity of the power supply circuit board through the conductive carrier 10.

The semiconductor light emitting structure 100A includes an epitaxy layer 103 composed of a first type semiconductor layer 104, an active layer 105 and a second type semiconductor layer 106 sequentially stacked. The first type semiconductor layer 104, the active layer 105 and the second type semiconductor layer 106 can be formed of a material selected from a group composed of gallium nitride (GaN), indium gallium nitride (InGaN), aluminum gallium nitride (AlGaN) or indium gallium aluminum nitride (AllnGaN) or a combination thereof. The first type semiconductor layer 104 and the second type semiconductor layer 106 respectively are an N type semiconductor layer and a P type semiconductor layer with opposite electric properties. The first electrode 101 is formed on the first type semiconductor layer 104 for transmitting and diffusing electrons to the epitaxy layer 103, such that the electrons and the holes in the epitaxy layer 103 are driven by a voltage and combined to emit a light.

Moreover, the semiconductor light emitting structure 100A further includes a transparent conductive layer 107, a Bragg reflective layer 108 and a metal layer 109. As indicated in FIG. 1, the transparent conductive layer 107 formed on the surface of the second type semiconductor layer 106 can be formed of such as indium tin oxide (ITO) or indium zinc oxide (IZO). The transparent conductive layer 107 makes the current uniformly diffused to the active layer 105 from the second type semiconductor layer 106 to avoid the situation that the current vertically passes through the epitaxy layer 103 and cannot be diffused horizontally.

As indicated in FIG. 1, the Bragg reflective layer 108 is formed on the surface of transparent conductive layer 107, and can be patterned by etching to form several blocks. In an embodiment, the Bragg reflective layer 108 covers more than 90% of the transparent conductive layer 107, and only less than 10% of the transparent conductive layer 107 is not covered by the Bragg reflective layer 108. The Bragg reflective layer 108 has a concave portion C. The metal layer 109 covers the Bragg reflective layer 108 and is put into the concave portion C, such that the metal layer 109 has a current conducting portion P embedded into the concave portion and electrically connected to the transparent conductive layer 107. That is, the current can flow to the second type semiconductor layer 106 through the current conducting portion P.

The transparent conductive layer 107 can be used as an Ohmic contact layer between the metal layer 109 and the second type semiconductor layer 106 to reduce the contact impedance between the metal layer 109 and the second type semiconductor layer 106.

In an embodiment, the Bragg reflective layer 108 can be formed of materials with high index of refraction staggered with materials with low index of refraction to form a plurality of film layers. For example, the Bragg reflective layer 108 can be formed of several titanium dioxide films with an index of refraction of 2.5 alternately staggered with several silica films with an index of refraction of 1.47. The thickness of each film has much to do with the wavelength of the incident light. When the product of the index of refraction of each layer and the optical thickness is equal to 1/4 of the wavelength of the incident light, constructive interference will occur and make the incident light unable to penetrate the Bragg reflective layer 108 because the optical path difference between the incident light and the reflected light is exactly n times of the wavelength of the incident light (that is, nλ, n=1,2,3...). Thus, based on the above principles and material properties, the reflectivity of the incident light is changed such that the incident light within a specific range of wavelength can be reflected.

In an embodiment, the Bragg reflective layer 108 can have more than 14 or between 20∼30 films, and the larger the quantity of films, the more significant the effect of light reflection. Furthermore, the metal layer 109 can also be used as a reflective mirror of the semiconductor light emitting structure 100A. The metal layer 109 can be formed of silver or aluminum for example, such that the full wave-band instead of a specific range of wavelength of the incident light can be reflected by the metal layer 109. In an embodiment, when the incident angle of the incident light is smaller than a specific angle (such as 60 degree), the Bragg reflective layer 108 can reflect the incident light with a smaller incident angle. When the incident angle of the incident light is larger than a specific angle (such as 60 degree), the metal layer 109 can totally reflect the incident light with a larger incident angle and further increase the reflectivity of the incident light.

### Second Embodiment

Referring to FIG. 2, a cross-sectional view of a semiconductor light emitting structure 100B according to an embodiment of the invention is shown. Since the semiconductor light emitting structure 100B of the present embodiment is similar to the semiconductor light emitting structure 100A of the first embodiment, designations common to the accompanying drawings are used to indicate identical or similar elements, and the similarities are not repeated here. In the present embodiment, the Bragg reflective layer 108 has a first concave portion C1 into which the metal layer 109 is put, such that the metal layer 109 has a current conducting portion P embedded into the first concave portion C1 and electrically connected to the transparent conductive layer 107. Besides, the transparent conductive layer 107 has a second concave portion C2 into which the Bragg reflective layer 108 is put, such that the Bragg reflective layer 108 has a current blocking portion B embedded into the second concave portion C2. The current blocking portion B contacts the second type semiconductor layer 106.

The transparent conductive layer 107 can be arranged in the form of sheets or blocks, and each part of the transparent conductive layer 107 arranged in the form of sheets or blocks is basically located between two adjacent first electrodes 101 arranged in the form of stripes.

In an embodiment, the position of the first electrode 101 is vertically aligned with that of the current blocking portion B, hence directly affecting the mobility of the electrons in the vertical direction. Therefore, the current blocking portion B formed of the Bragg reflective layer 108 is used to avoid the situation that the electrons vertically pass through the epitaxy layer 103 from the first electrode 101 and cannot be diffused horizontally.

### Third Embodiment

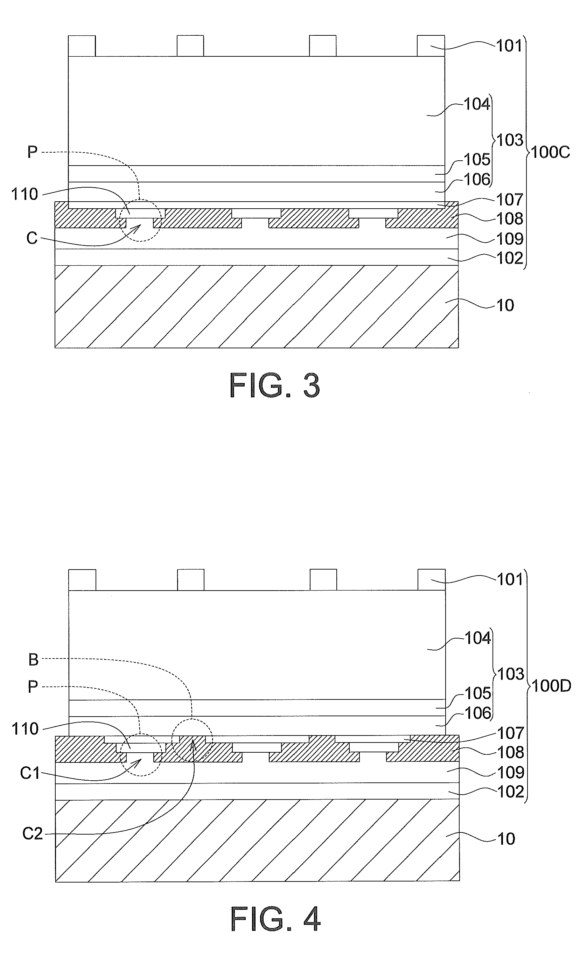

Referring to FIG. 3, a cross-sectional view of a semiconductor light emitting structure 100C according to an embodiment of the invention is shown. Since the semiconductor light emitting structure 100C of the present embodiment is similar to the semiconductor light emitting structure 100A of the first embodiment, designations common to the accompanying drawings are used to indicate identical or similar elements, and the similarities are not repeated here. In the present embodiment, the Bragg reflective layer 108 has a concave portion C. The metal layer 109 covers the surface of the Bragg reflective layer 108. The metal layer 109 is put into the concave portion C, such that the metal layer 109 has a current conducting portion P embedded into the concave portion C. Moreover, the semiconductor light emitting structure 100C of the present embodiment further includes a contact pad 110 formed on the surface of the transparent conductive layer 107 and located between the current conducting portion P and the transparent conductive layer 107.

In an embodiment, the contact pad can be formed of a metal, such as nickel, copper or aluminum. The contact pad 110 can be used as an etching blocking layer. As indicated in FIG. 3, the contact pad 110 is formed on the surface of the transparent conductive layer 107 and inside the concave portion C of the Bragg reflective layer 108. Therefore, when an etching solution is used to etch the Bragg reflective layer 108 to form the concave portion C, the etching solution is blocked by the contact pad 110, such that the transparent conductive layer 107 covered by the contact pad 110 will not be etched by the etching solution.

### Fourth Embodiment

Referring to FIG. 4, a cross-sectional view of a semiconductor light emitting structure 100D according to an embodiment of the invention is shown. Since the semiconductor light emitting structure 100D of the present embodiment is similar to the semiconductor light emitting structure 100A of the second embodiment, designations common to the accompanying drawings are used to indicate identical or similar elements, and the similarities are not repeated here. In the present embodiment, the Bragg reflective layer 108 has a first concave portion C1 into which the metal layer 109 is put, such that the metal layer 109 has a current conducting portion P embedded into the first concave portion C1. Furthermore, the transparent conductive layer 107 has a second concave portion C2 into which the Bragg reflective layer 108 is embedded, such that the Bragg reflective layer 108 has a current blocking portion B embedded into the second concave portion C2. The semiconductor light emitting structure 100D of the present embodiment further includes a contact pad 110 formed on the surface of the transparent conductive layer 107 and located between the current conducting portion P and the transparent conductive layer 107.

The transparent conductive layer 107 can be arranged in the form of sheets or blocks, and each part of the transparent conductive layer 107 arranged in the form of sheets or blocks is basically located between two adjacent first electrodes 101 arranged in the form of stripes.

In an embodiment, the position of the first electrode 101 is vertically aligned with that of the current blocking portion B, hence directly affecting the mobility of the electrons in the vertical direction. Therefore, the current blocking portion B formed of the Bragg reflective layer 108 is used to avoid the situation that the electrons vertically pass through the epitaxy layer 103 from the first electrode 101 and cannot be diffused horizontally.

### Fifth Embodiment

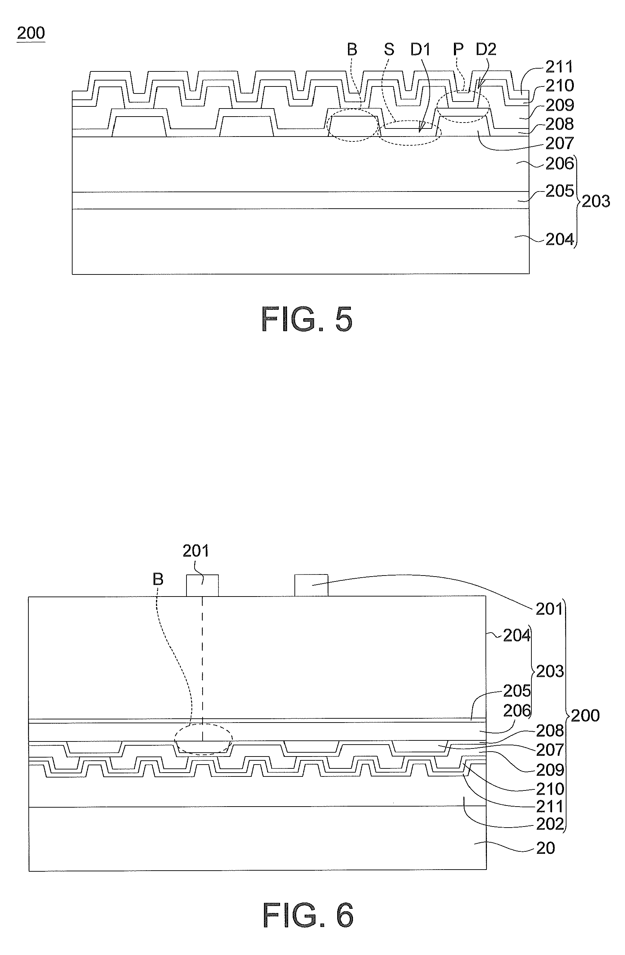

Referring to FIG. 5, a cross-sectional view of a semiconductor light emitting structure 200 according to an embodiment of the invention is shown. The semiconductor light emitting structure 200 includes an epitaxy layer 203 composed of a first type semiconductor layer 204, an active layer 205 and a second type semiconductor layer 206 sequentially stacked. Detailed structures and descriptions of the epitaxy layer 203 are disclosed as those of the epitaxy layer 103 in the first embodiment, and are not repeated here.

Besides, the semiconductor light emitting structure 200 further includes a first Bragg reflective layer 207, a transparent conductive layer 208, a second Bragg reflective layer 209, a metal layer 210 and a barrier layer 211. The first Bragg reflective layer 207 is formed on the surface of the second type semiconductor layer 206. The transparent conductive layer 208 is formed on the surface of the first Bragg reflective layer 207. The second Bragg reflective layer 209 is formed on the surface of the transparent conductive layer 208. The metal layer 210 is formed on the surface of the second Bragg reflective layer 209.

As indicated in FIG. 5, the transparent conductive layer 208 can be formed of indium tin oxide (ITO) or indium zinc oxide (IZO). The transparent conductive layer 208 makes the current uniformly diffused to the active layer 205 from the second type semiconductor layer 206 to avoid the situation that the current vertically passes through the epitaxy layer 203 and cannot be diffused horizontally. Besides, the transparent conductive layer 208 can further be used as an Ohmic contact layer between the metal layer 210 and the second type semiconductor layer 206 to reduce the contact impedance between the metal layer 210 and the second type semiconductor layer 206.

As indicated in FIG. 5, the first Bragg reflective layer 207 is formed on the surface of the second type semiconductor layer 206, and can be patterned by etching to form several blocks. In an embodiment, the first Bragg reflective layer 207 covers 5∼10% of the second type semiconductor layer 206, and about 95∼90% of the second type semiconductor layer 206 is not covered by the first Bragg reflective layer 207.

The first Bragg reflective layer 207 has a first recess D1. The transparent conductive layer 208 and the second Bragg reflective layer 209 are put into the first recess D1, such that the transparent conductive layer 208 has a current diffusion portion S embedded into the first recess D1 and electrically connected to the second type semiconductor layer 206. That is, the current can flow to the second type semiconductor layer 206 through the current diffusion portion S.

Moreover, the second Bragg reflective layer 209 is formed on the surface of the transparent conductive layer 208, and can be patterned by etching to form several recessed regions. In an embodiment, the second Bragg reflective layer 209 covers about 95∼90% of the area of the transparent conductive layer 208, and only about 5∼10% of the transparent conductive layer 208 is not covered by the second Bragg reflective layer 209. The first and the second Bragg reflective layers 207 and 209 are staggered and partly overlapping each other. Therefore, the first and the second Bragg reflective layers 207 and 209 cover the entire area of the second type semiconductor layer 206.

The second Bragg reflective layer 209 has a second recess D2 into which the metal layer 210 and the barrier layer 211 are put, such that the metal layer 210 has a current conducting portion P embedded into the second recess D2 and electrically connected to the transparent conductive layer 208. That is, the current can flow the transparent conductive layer 208 through the current conducting portion P and then flow to the second type semiconductor layer 206 through the current diffusion portion S of the transparent conductive layer 208.

Furthermore, the first Bragg reflective layer 207 corresponding to the current conducting portion P forms a current blocking portion B and contact the second type semiconductor layer 206. Referring to FIG. 6, a cross-sectional view of a semiconductor light emitting structure 200 used as vertical LED according to an embodiment of the invention is shown. The semiconductor light emitting structure 200 further includes a first electrode 201 and a second electrode 202. The first electrode 201 is formed on the first type semiconductor layer 204. The first electrode 201 and the current blocking portion B are disposed on two opposite sides of the epitaxy layer 203, and the position of the first electrode 201 is vertically aligned with that of the current blocking portion B. The first electrode 201 can be electrically connected to the negative polarity of a power supply circuit board (not illustrated) through wires (not illustrated), and the second electrode 202 can be electrically connected to the positive polarity of the power supply circuit board through the conductive carrier 20.

The position of the first electrode 201 is vertically aligned with that of the current blocking portion B, hence directly affecting the mobility of the electrons in the vertical direction. Therefore, the current blocking portion B formed of the Bragg reflective layer 207 is used to avoid the situation that the electrons vertically pass through the epitaxy layer 203 from the first electrode 201 and cannot be diffused horizontally.

In an embodiment, the first and the second Bragg reflective layers 207 and 209 can be formed of materials with high index of refraction staggered with materials with low index of refraction to form a plurality of film layers. For example, the first and the second Bragg reflective layers 207 and 209 can be formed of several titanium dioxide films with an index of refraction of 2.5 alternately staggered with several silica films with an index of refraction of 1.47. Each of the first and the second Bragg reflective layers 207 and 209 can have more than 14 or 20∼30 films, and the larger the quantity of films, the more significant the effect of light reflection. When the second Bragg reflective layer 209 has more films than the first Bragg reflective layer 207, the reflectivity of the second Bragg reflective layer 209 will be larger than that of the first Bragg reflective layer 207.

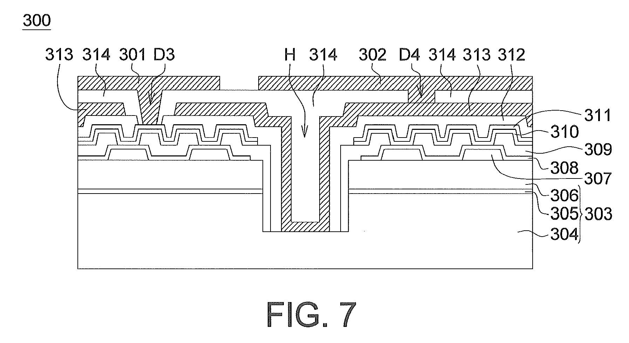

Referring to FIG. 7, a cross-sectional view of a semiconductor light emitting structure 300 used as a flip-chip LED according to an embodiment of the invention is shown. Elements with designations 303∼311 of the present are the same elements with designations 203∼211 of the above embodiments, and the similarities are not repeated here. The semiconductor light emitting structure 300 includes a first electrode 301 and a second electrode 302, which are disposed on the same side of the epitaxy layer 303. The first electrode 301, such as a P-type electrode, can be electrically connected to the positive polarity of a power supply circuit board (not illustrated) through a conductive bump (not illustrated). The second electrode 302, such as an N-type electrode, can be electrically connected to the negative polarity of the power supply circuit board through another conductive bump (not illustrated).

In the present embodiment, the semiconductor light emitting structure 300 further includes a first protection layer 312, a contact layer 313 and a second protection layer 314. The first protection layer 312 covers the metal layer 309, and is formed in a through hole H passing through the second type semiconductor layer 306, the active layer 305 and a part of the first type semiconductor layer 304. The first Bragg reflective layer 307, the transparent conductive layer 308, the metal layer 310 and the barrier layer 311 are located on the surface surrounding the periphery of the through hole H. The second Bragg reflective layer 309 further selectively covers the sidewall of the through hole H in addition to the surface surrounding the periphery of the through hole H.

The contact layer 313 is disposed on the first protection layer 312, and is electrically connected to the first type semiconductor layer 304 in the through hole H. Besides, the second protection layer 314 covers the contact layer 313, and can be put into the through hole H. The second protection layer 314 has a third recess D3 and a fourth recess D4. The third recess D3 passes through the contact layer 313 and the first protection layer 312 to reach the surface of the barrier layer 311. The first electrode 301 is disposed on the second protection layer 314 and put into the third recess D3 to be electrically connected to the metal layer 310 (disposed under the barrier layer 311). Moreover, the second electrode 302 is disposed on the second protection layer 314 and put into fourth recess D4 to be electrically connected to the contact layer 313.

According to the semiconductor light emitting structure disclosed in above embodiments of the invention, the transparent conductive layer formed of ITO and the Bragg reflective layer are used to replace the conventional Ohmic contact layer and the reflective mirror formed of silver to increase the yield rate in the manufacturing process. Additionally, the Bragg reflective layer can be used as a reflective mirror of the vertical LED or the flip-chip LED, such that the reflectivity of the light with a wavelength within the range of visible light or UV light (such as between 340nm∼420nm or between 360nm∼400nm) can reach 90% and above or even 100% to improve the overall luminous efficiency. Additionally, the Bragg reflective layer can further be used as a current blocking layer to avoid the situation that the current vertically passes through the epitaxy layer from the electrode and cannot be diffused horizontally.

While the invention has been described by way of example and in terms of the preferred embodiment(s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A semiconductor light emitting structure, **characterized in that** the semiconductor light emitting structure (100A, 100B, 100C, 100D) comprises:
a first type semiconductor layer(104);
an active layer(105);
a second type semiconductor layer(106), wherein the second type semiconductor layer, the active layer and the first type semiconductor layer are stacked sequentially to form an epitaxy layer(103);
an electrode (101) formed on the first type semiconductor layer;
a transparent conductive layer(107) formed on the second type semiconductor layer;
a Bragg reflective layer (108) formed on the transparent conductive layer(107), wherein the Bragg reflective layer (108) and the electrode (101) are formed on two opposite sides of the epitaxy layer(103); and
a metal layer(109) formed on the Bragg reflective layer(108).
wherein, the Bragg reflective layer has a first concave portion(C, C1) into which the metal layer(109) is put, such that the metal layer has a current conducting portion (P) embedded into the first concave portion (C, C1) and electrically connected to the transparent conductive layer(107).

2. The semiconductor light emitting structure according to claim 1, further comprising a contact pad (110) formed on the transparent conductive layer(107) and located between the current conducting portion (P) and the transparent conductive layer(107).

3. The semiconductor light emitting structure according to claim 1, wherein the transparent conductive layer(107) has a second concave portion (C2) into which the Bragg reflective layer(108) is embedded, such that the Bragg reflective layer(108) has a current blocking portion (B) embedded into the second concave portion (C2) and electrically connected to the second type semiconductor layer(106).

4. The semiconductor light emitting structure according to claim 3, wherein the position of the electrode(101) is aligned with that of the current blocking portion (B).

5. The semiconductor light emitting structure according to claim 3, further comprising a contact pad(110) formed on the transparent conductive layer(107) and located between the current conducting portion(P) and the transparent conductive layer(107).

6. A semiconductor light emitting structure, **characterized in that** the semiconductor light emitting structure (200, 300)comprises:
a first type semiconductor layer(204, 304);
an active layer(205, 305);
a second type semiconductor layer(206, 306), wherein the second type semiconductor layer, the active layer and the first type semiconductor layer are stacked sequentially to form an epitaxy layer(203, 303);
a first Bragg reflective layer(207, 307) formed on the second type semiconductor layer.
a transparent conductive layer(208, 308) formed on the first Bragg reflective layer;
a second Bragg reflective layer(209, 309) formed on the transparent conductive layer, wherein the first Bragg reflective layer has a first recess(D1) into which the transparent conductive layer(208, 308) and the second Bragg reflective layer(209, 309) are put, such that the transparent conductive layer(208, 308) has a current diffusion portion(S) embedded into the first recess(D1); and
a metal layer(21 0, 310) formed on the second Bragg reflective layer, wherein the second Bragg reflective layer has a second recess(D2) into which the metal layer(210, 310) is put, such that the metal layer(210, 310) has a current conducting portion(P) embedded into the second recess(D2) and electrically connected to the transparent conductive layer(208, 308).

7. The semiconductor light emitting structure according to claim 6, wherein the first Bragg reflective layer(207, 307) corresponding to the current conducting portion(P) and forms a current blocking portion(B).

8. The semiconductor light emitting structure according to claim 6, wherein a reflectivity of the second Bragg reflective layer(209, 309) is larger than a reflectivity of the first Bragg reflective layer(207, 307).

9. The semiconductor light emitting structure according to claim 7, further comprising an electrode(201) formed on the first type semiconductor(204), wherein the electrode(201) and the current blocking portion(B) are disposed on two opposite sides of the epitaxy layer(203), and the position of the electrode(201) is aligned with that of the current blocking portion(B).

10. The semiconductor light emitting structure according to claim 6, further comprising:
a first protection layer(312) covering the metal layer(310) and formed in a through hole(H) passing through the second type semiconductor layer(306), the active layer(305) and a part of the first type semiconductor layer(304);
a contact layer(313) disposed on the first protection layer(312), wherein the contact layer(313) is electrically connected to the first type semiconductor layer(304) in the through hole(H);
a second protection layer(314) covering the contact layer(313), wherein the second protection layer(314) has a third recess(D3) and a fourth recess(D4);
a first electrode(301) disposed on the second protection layer(314) and put into the third recess(D3) to be electrically connected to the metal layer(310); and
a second electrode(302) disposed on the second protection layer(314) and put into the fourth recess(D4) to be electrically connected to the contact layer(313).
